# EUROPEAN PATENT APPLICATION

(11) **EP 4 387 407 A1**
(43) Date of publication of application: **19.06.2024**
(21) Application number: 22212981.9
(22) Date of filing: 13.12.2022
(51) Int. Cl.: H05K 9/00

(54) **ELECTRONIC COMPONENT BOX FOR A HEAT PUMP SYSTEM**

(71) Applicant: BDR Thermea Group B.V., 7332 BD Apeldoorn (NL)
(72) Inventor: BICHLER, Arnaud, 7332 BD Apeldoorn (NL); BASCH, Joachim, 7332 BD Apeldoorn (NL); MANSUY, Cédric, 7332 BD Apeldoorn (NL); ANTOINE, Florian, 7332 BD Apeldoorn (NL)
(74) Representative: Dennemeyer & Associates S.A.

(57) **Abstract**

The invention relates to an electronic component box (9) for a heat pump system (1). The electronic component box (9) comprises a casing (11) that is arranged to hold electronic components (15) in an inner space of the casing (11). The casing (11) is made from at least a first and a second material. The first material being plastic, shaped to hold at least one of the electronic components (15) at a fixed position within the casing (11) and the second material having an electrical conductivity higher than an electrical conductivity of the first material.

## Description

The invention relates to an electronic component box. In addition, the invention relates to a heat pump comprising such an electronic component box and a method for manufacturing such an electronic component box.

Heat pump systems are getting more and more sophisticated and therefore more and more electronic components are used for the control of heat pump systems. These electronic components may be provided in electronic component boxes.

Typically, electronic component boxes are made from steel sheets to shield the electronic components from outside influences such as electromagnetic interferences and to avoid the electronic components from disturbing the external environment, as laid down in the Electro Magnetic Compatibility standard. However, the design options for electronic boxes made from steel sheets are limited, as dimension and shape options of steel sheets are limited.

For instance, creating shapes that allow to clip electronic components into the electronic component box is difficult, if not impossible, as steel sheets cannot be (easily) folded in such shapes. The use of steel sheets and its manufacturing process does not allow for the integration of holding functions for electronic components as the shapes and geometries for forming the steel sheets are limited.

Moreover, electronic component boxes made of steel sheets reduces the transmission of electronic waves (such as Wi-Fi or Bluetooth), thus limiting the possibilities of a remote connection with components of the heat pump system inside the electronic component box.

These problems can be overcome by using plastic parts to make electronic component boxes. Plastic can easily be moulded in many different shapes, such that it can enclose all the components while also holding the components in a fixed and defined space by enclosing each component. In addition, electronic waves can pass through plastic.

However, using plastic has the disadvantage that the components inside the electronic component box are not well shielded from electromagnetic interferences from outside the electronic component box and electromagnetic interference may be transmitted from the electronic component box.

The object of the invention is therefore to provide an electronic component box for a heat pump system that isolates the inner space from the electronic component box from the environment and providing freedom of design.

The object is solved by an electronic component box for a heat pump system wherein the electronic component box comprises a casing that is arranged to hold electronic components in an inner space of the casing, wherein the casing is made from at least a first and a second material,
- the first material being plastic, shaped to hold at least one of the electronic components at a fixed position within the casing and
- the second material having an electrical conductivity higher than an electrical conductivity of the first material.

By realizing an electronic component box for a heat pump system with a casing composed of a plastic and an electric conductive element, complex geometries and structures can be formed relatively easily for holding electronic components, while at the same time the electronic components can be isolated from electromagnetic interferences. Transmission of electromagnetic waves for communication purposes can be made possible by applying the second material selectively on the casing.

It is observed that there is a significant reduction of electromagnetic radiation emitted and received by the electronic components in the electromagnetic box on certain frequencies. This will be explained in more detail with reference to the Figures.

The casing forms a substantially closed housing of any suitable shape. The casing may be water-tight to protect the electronic components against water and/or may comprise guides for electrical wires as well as guides for guiding water around and away from the inner space.

The use of plastic provides much freedom to make shapes relatively easily to hold electronic components at a fixed position within the casing, such as by way of clipping via pins, slides, screwing barrels etc. Also, further shapes and functions can be provided such as vents, ventilation holes, card clips, cable/wire guides, means of closing and locking etc. In this way, various functions of the electronic component box can be integrated into the design of the casing.

Compared to an electronic component box made of steel, construction requires steel plates that need to be connected with screws, plastic clips, rings etc.. to fix the boards and wires. This introduces risk of incorrect assembly, risk of cutting cables and causing electrical hazards or a product defect. Furthermore, such an electronic component box is difficult to recycle, because of the use of different materials in large quantities. All these disadvantages are overcome by the currently presented electronic component box.

The use of plastic limits the noise from shocks and vibrations. Where steel parts may generate noise caused by shocks and vibrations of the heat pump system, such noise is eliminated by the use of plastic.

By adding a second material, the whole part can be stronger than with first material alone, thereby allowing to reduce the quantity of needed from the first material. For instance, when adding graphene, the amount of plastic material may be significantly reduced, which is beneficial for the ecological footprint of the electronic components box (use of fossil materials for producing, manufacturing, transporting and recycling).

Furthermore, the thermal dissipation of the casing may be improved by the use of a second material. For instance, when adding graphene, the thermal dissipation of the heat generated by the electronic components is improved thanks to the thermal conductivity of graphene.

The casing may be made of a graphene-filled material or may have a graphene coating.

According to an embodiment the second material has an electrical conductivity of at least
- a 10⁹ times higher than the electrical conductivity of the first material expressed in S/m at 293°K, and/or
- 10⁶ S/m at 293°K, or
- 10⁷ S/m at 293°K.

Plastics typically have a low electric conductivity, e.g. in the range of 10⁻¹⁰ S/m - 10⁻²¹ S/m. Plastics are considered insulators. The second material is selected to have a high electrical conductivity. The second material may be referred to as a conductor. Thus, according to an embodiment the first material is an electrical insulator and the second material is an electrical conductor.

By adding the second material having a high electrical conductivity, the second material compensates for the low conductivity of the first material, i.e. plastic. The second material allows to benefit from the qualities of the plastic (mouldability, function integration, cost, recyclability, etc.) while at the same time integrating conductive qualities to be compatible with the electric requirements in terms of shielding the electronic components from interference.

According to an embodiment the thickness of the casing is in the range of 1.5 - 4 mm and the first material is or comprises a
- thermoplastic, and/or
- polycarbonate (PC), and/or
- acrylonitrile butadiene styrene (ABS) and/or
- mixture of polycarbonate and acrylonitrile butadiene styrene (PC + ABS) , and/or
- fibre or glass fibre.

These materials allow for easy manufacturing (moulding), while having a low electrical conductivity. The first material may comprise (glass) fibre to create a stronger material.

The first material may be injected plastic.

According to an embodiment the second material is or comprises graphene.

Graphene has the advantage that it can be applied in very thin layers, having a thickness in the order of nanometers.

According to an embodiment the second material is provided as a coating layer on the first material, the coating layer being provided on a side of the casing facing the inner space and/or on a side of the casing facing an outer space of the casing. Applying the second material as a coating on the inside of the casing is preferred as it provides better results.

Preferably, the entire casing is covered creating a three-dimensional barrier for electromagnetic waves.

According to an embodiment the thickness of the coating layer is greater than 0.34 nm and/or less than 7 nm.

A coating layer is created by adding the second material on the surface of the first material. It can be applied by spraying with a liquid (such as water) in liquid phase or can be added in as a powder. If sprayed, the liquid can evaporate to let only the material required (graphene) behind. If applied as a powder, an electrostatic process can be applied so that the powder covers the surface of the first material, e.g. the surface is charged positively or negatively and the powder is charged with the opposite load).

When spraying a single layer, a coating layer of approximately 0.34 nm is created. It is preferred to use at least 2 layers, so a thickness of the coating layer of approximately 0.68 nm. Preferably a maximum of 10 layers are applied.

According to an embodiment the first and second materials are mixed in a ratio of between 5 - 100 gram of the second material per litre of the first material.

The second material may be mixed with the first material, being a plastic melt. Then the mixture is injected to get the intended shape. The secons material may be 1 - 20 weight percent of the mixture.

According to an embodiment the casing comprises one or more sections made from
- the first material only and/or
- without the second material.

The second material may be applied throughout the entire casing or around the entire periphery of the casing, but alternatively, one or more sections of the casing may be made without the second material to create non-conductive passageways for electromagnetic signals.

This allows for integration of electromagnetically sensitive electronic components, like power or control boards, into the casing, while also integrating communication components, like Bluetooth or wireless internet components. The communication components are preferably positioned in the casing close to the one or more sections of the casing made from the first material only. This way, localized management of blocking zones and communication zones is made possible thanks to the localization of the conductive second material.

According to an alternative, one or more communication components, like Bluetooth or wireless internet components, are positioned on the outside of the casing.

According to an embodiment the casing comprises ventilation openings and/or water guides. This allows for effective cooling of the electrical components.

Ventilation openings ensures cooling of the electronic components, while water guides help to guide water along the casing preventing the water from entering the inner space of the casing, as well as guide water out of the inner space. Baffles may be provided, integrated in the ventilation openings, preventing objects (dust, residues, water) from entering the casing via the ventilation openings, while air can flow in and out. The baffles also prevent direct emission of electromagnetic waves.

According to an embodiment the electronic component box is configured to be attached to the heat pump system by means of at least one hinge to move the electronic component box between an operating position and a range of maintenance positions, wherein the at least one hinge has at least one stop position associated with a maintenance position to hold the electronic component box in such maintenance position.

It will be understood that the hinge may be provided in several manners. The electronic component box may comprise at least one first hinge part, where at least a second hinge part is attached to the heat pump system, e.g. the housing, allowing the respective first and second hinge parts to be connected to each other forming a hinge. Alternatively, the electronic component box may comprise a hinge, which is connectable (e.g. by means of screws) to the rest of the heat pump system, e.g. the housing. Alternatively, the heat pump system comprises a hinge, which is connectable (e.g. by means of screws) to the electronic component box.

The hinge may comprise a male and a female part, which when assembled, allow rotation of the male part with respect to the female part.

In the operating position, the electronic component box fits in the housing of the heat pump system but may obstruct view and access for an operator to the internals of the heat pump system, such as the hydraulics and refrigerant carrying components, such as the compressor, the expansion valve and heat exchangers. During maintenance, the electronic component box can be moved to a maintenance position, typically outside the space defined by the housing, in which the electronic component box no longer obstructs view and access to the internals of the heat pump system.

This embodiment provides the advantage that a compact housing may be used, while during maintenance the electronic component box can be moved from the operating position to the maintenance position facilitating maintenance. The at least one hinge is configured to hold the electronic component box in one or more maintenance positions. The at least one hinge may have more than one stop position. Stop positions may be provided at 45°, 90°, 135° and/or 180°. This is advantageous in situations where the door part cannot be fully opened, for instance because of an obstacle preventing further opening (wall) and/or to keep the door part open without further aid. The door part can be moved from the maintenance position by simply pushing or pulling the door part.

According to an embodiment the inner space comprises an intermediate plane defining a first and a second spaces, wherein
- the first space comprises or is configured to comprise electronic cards and power management elements, and/or
- the second space comprises or is configured to comprise electrical wirings, and/or
- the intermediate plane comprises openings to accommodate wiring to run between the first and second space, and/or
- the casing comprises a main body part defining an opening and at least one moveable or removeable cover part to cover the opening, wherein the first space is closer to the opening than the second space.

By dividing the inner space into a first and second space, it is possible to organize the wiring of the electronic components in a clear and efficient manner. Operators opening the casing by removing the cover part get a clear view on the electronic components without being troubled by wires. This allows for better reading, accessibility and handling of the electronic components. Also, when repositioning the cover part to close the opening, the risk of wires getting caught and damaged is reduced.

The intermediate plane may be substantially parallel to the opening, such that when removing the cover, easy access is provided to the first space, while the second space is shielded.

The at least one cover part may be attached to the main body part by one or more hinges.

According to a further aspect there is provided a heat pump system comprising an electronic component box according to the above.

As described above, the electronic component box may be attached to the heat pump system by means of at least one hinge to move the electronic component box between an operating position and a range of maintenance positions, wherein the at least one hinge has at least one stop position associated with a maintenance position to hold the electronic component box in such maintenance position.

According to a further aspect there is provided a method for manufacturing an electronic component box for a heat pump system, wherein the electronic component box comprises a casing that is arranged to hold electronic components in an inner space of the casing, wherein method comprises
- providing a first material, the first material being plastic,
- providing a second material, the second material having an electrical conductivity higher than an electrical conductivity of the first material,
- forming the casing from the first and second material.

Forming the casing may be done by moulding. Compared to using steel sheets, no cutting or the like is required, which improves the safety and dimensional repeatability.

According to an embodiment forming the casing from the first and second material comprises:
- shaping the first material to form the casing, the casing being shaped to hold at least one of the electronic components at a fixed position within the casing, and
- applying a coating layer of the second material on at least parts of the casing.

The casing may be formed by one or more parts, e.g. a main body part and a cover part. The coating layer may be provided on the outside or on the inside of the casing. If applied on the inside, it is preferred to first apply the coating layer before different parts (e.g. main body part and cover part) of the casing are assembled.

According to an embodiment forming the casing from the first and second material comprises:
- mixing the first and second material to form a mixed material,
- shaping the mixed material to form the casing, the casing being shaped to hold at least one of the electronic components at a fixed position within the casing.

The casing may be formed as a single piece or as an assembly of parts, such as for instance a main body part and a door part.

In the figures, the subject-matter of the invention is schematically shown, wherein identical or similarly acting elements are usually provided with the same reference signs.
- Figure 1: schematically shows a heat pump system,
- Figure 2: schematically shows part of the internals of a heat pump system,
- Figures 3a-b: schematically show a heat pump system with the electronic component box in different maintenance positions,
- Figure 4: schematically shows a hinge for attaching the electronic component box to the heat pump system,
- Figures 5a-b: schematically show the electronic component box.

Embodiments will be described below with reference to the accompanying figures.

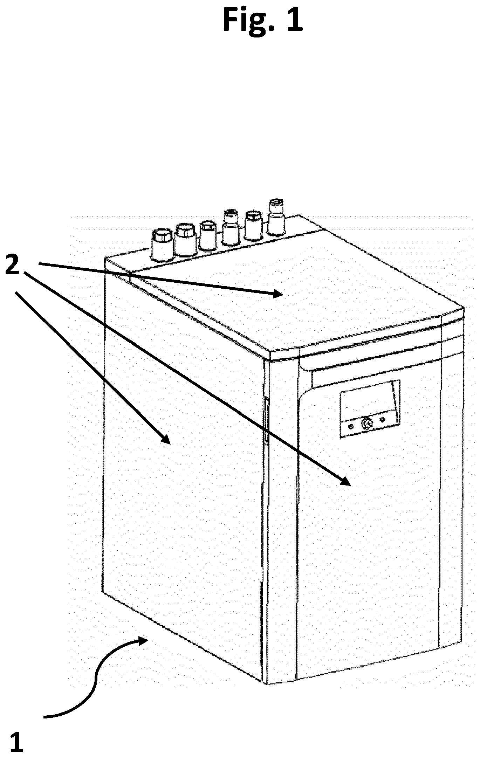

Fig. 1 shows a heat pump system 1. The heat pump system has a housing formed by a plurality of panels 2.

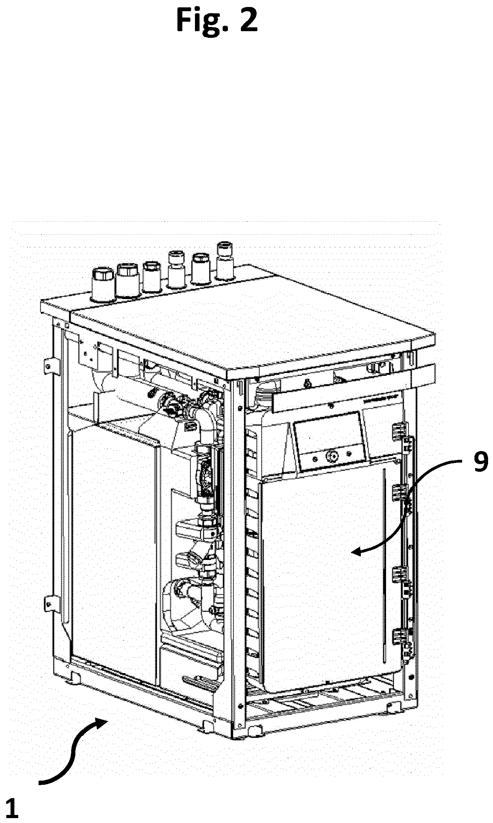

Fig. 2 shows the heat pump system 1 with some panels 2 removed, revealing an electronic component box 9, which will be described in more detail below. The electronic component box 9 is attached by means of hinges allowing the electronic component box 9 to be rotated, providing access and view on the internals of the heat pump system 1, as shown in Fig.'s 3a and b.

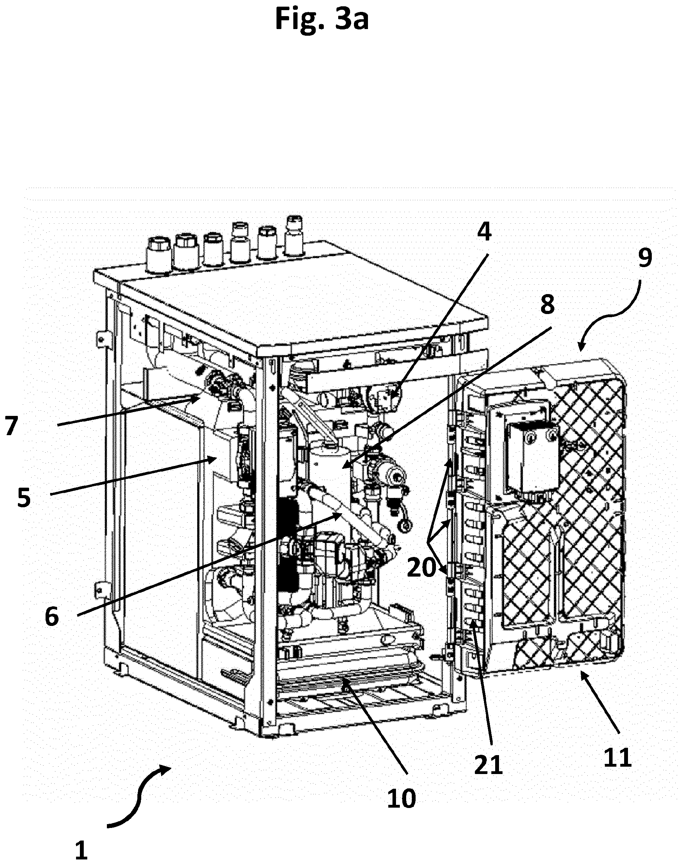

As shown in Fig. 3a, the heat pump system 1 comprises a hydraulic pump 4, hydraulic piping 6, hydraulic connection 7 between hydraulic drawer 5 and hydraulic network, additional heater 8, expansion vessel 10. It will be understood that the heat pump system comprises further parts not shown or indicated as such in Fig. 3a, such as refrigerant carrying components, such as an evaporator, compressor, condenser and expansion valve.

The electronic component box 9 as shown in Fig. 3a comprises a casing 11 that is arranged to hold electronic components in an inner space of the casing, wherein the casing is made from at least a first and a second material,
- the first material being plastic, shaped to hold at least one of the electronic components at a fixed position within the casing and
- the second material having an electrical conductivity higher than an electrical conductivity of the first material. This will be explained in more detail below.

The second material may have an electrical conductivity higher than that of the first material, for instance more than 10⁶ S/m at 293°K and may be graphene. According to the embodiment shown, the first material is a thermoplastic and the second material is graphene. The casing may be made from a graphene-filled plastic material, wherein the first and second materials are mixed in a ratio of between 5 - 100 gram of the second material per litre of the first material. According to an alternative embodiment, the casing has a graphene coating layer with a thickness in the range of 0.34 nm - 5 nm.

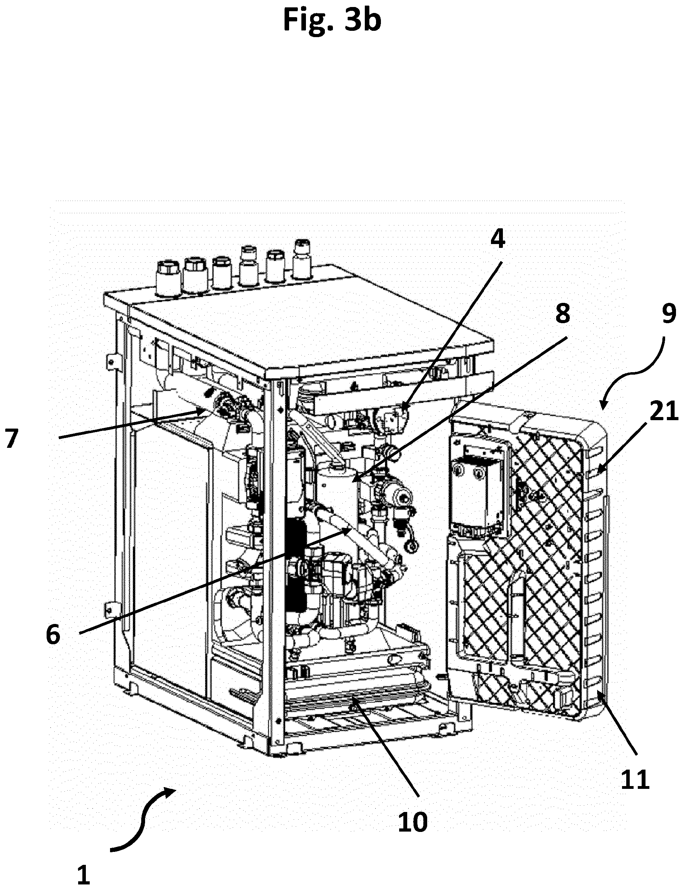

As shown in Fig. 3a, the electronic component box 9 is attached to the heat pump system 1 by means of three hinges 20 to move the electronic component box 9 between an operating position (shown in Fig. 2) and a range of maintenance positions, of which one is shown in Fig. 3a and another maintenance position is shown in Fig. 3b. The hinges 20 have at least one stop position associated with a maintenance position to hold the electronic component box in such maintenance position. Several ventilation holes 21 are provided on both length sides of the electronic component box 9.

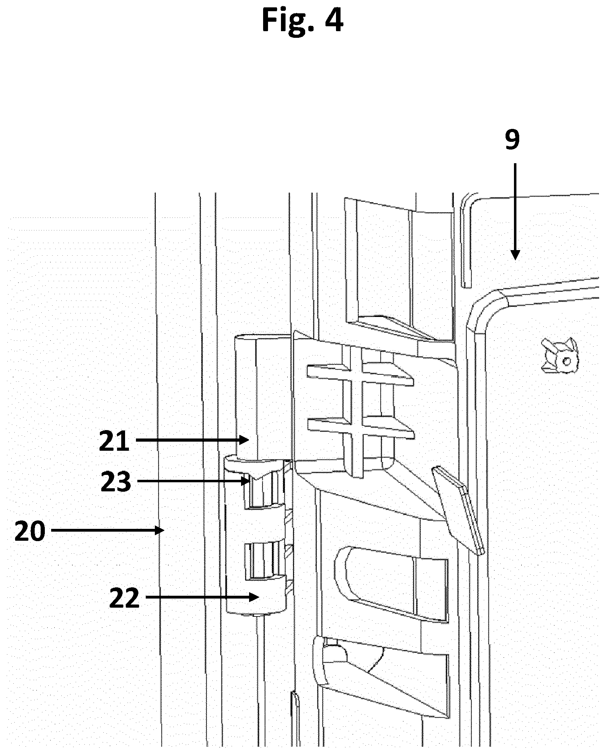

Fig. 4 shows a hinge 20 in more detail. As shown in Fig. 4, the hinge may be formed by a female part 21 connected to the heat pump system 1, for instance to one of the heat pump housing panels 2 and a male part 22 connected to the electronic component box 9. The male part 22 may comprise a protrusion 23 that interacts with the female part 21 such that rotation is stopped at one or more stop positions. The female part 21 may have recesses associated with the stop positions for receiving the protrusion in such a way that additional force is required to rotate the male part 22 further.

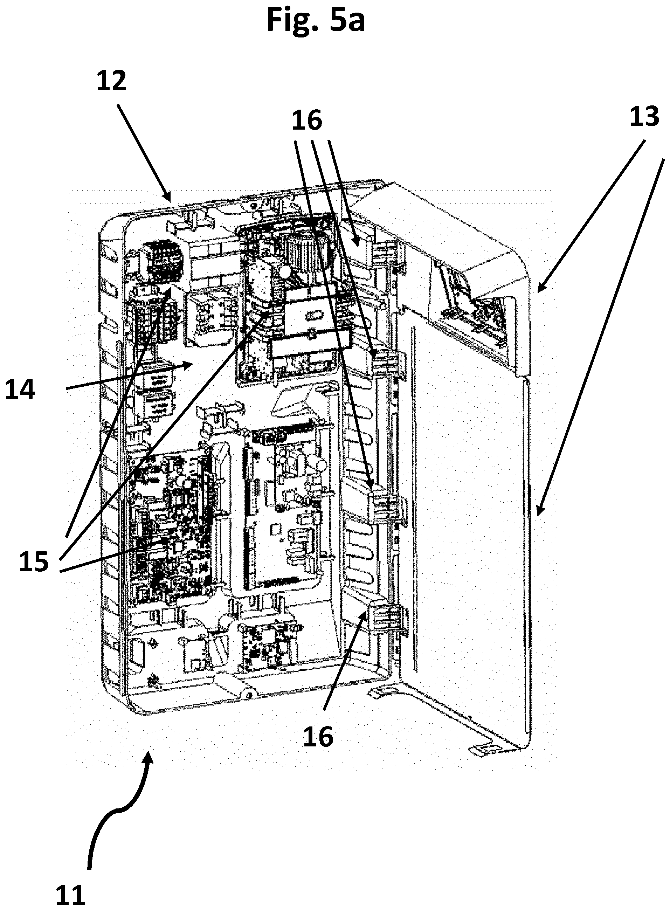

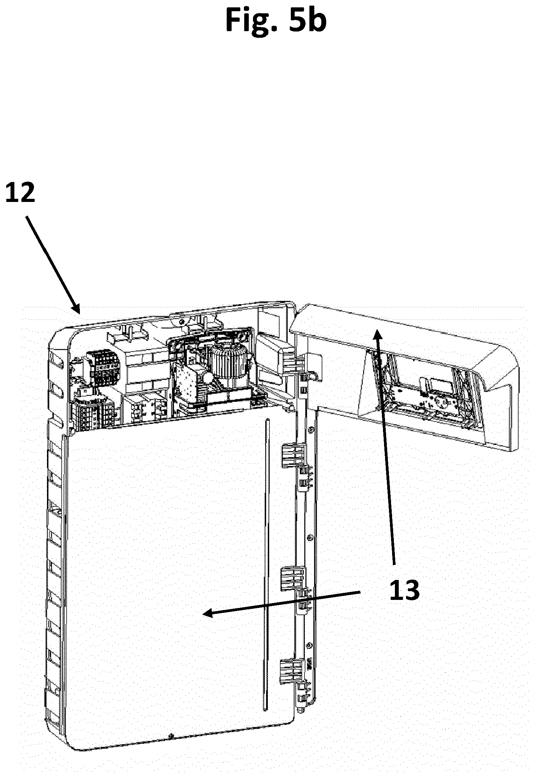

Fig. 5a shows a more detailed view of the electronic component box 9. The casing 11 of the electronic component box 9 comprises a main body part 12 and two removeable or moveable cover parts 13. The cover parts 13 can be opened or closed.

The main body part 12 comprises an intermediate plane 14 defining a first and a second space. The first space comprises electronic components like electronic cards and power management elements, of which a few are referred to in Fig. 5a by means of reference 15.

Behind the intermediate plane, not visible in Fig. 5a, a second space is created which comprises electrical wirings, connected to the electronic components in the first space, to provide power to the electronic components and/or send signals to an/or from the electronic components.

The embodiment shown in Fig.'s 5a-b has two cover parts 13, which are attached to the main body part 12 by hinges 16, allowing the two cover parts 13 to be opened and closed independently.

### Reference Signs

- 1.: Heat pump system
- 2.: Heat pump housing panels
- 4.: Hydraulic pump
- 5.: Hydraulic drawer
- 6.: Hydraulic piping
- 7.: Hydraulic connection
- 8.: Additional heater
- 9.: Electric component box
- 10.: Expansion vessel
- 11.: Casing of the electronic component box
- 12.: Main body part
- 13.: Cover part
- 14.: Intermediate plane
- 15.: Electronic components
- 20.: Hinge
- 21: Ventilation opening

## Claims

1. Electronic component box (9) for a heat pump system (1) wherein the electronic component box (9) comprises a casing (11) that is arranged to hold electronic components (15) in an inner space of the casing (11), wherein the casing (11) is made from at least a first and a second material,
- the first material being plastic, shaped to hold at least one of the electronic components (15) at a fixed position within the casing (11) and
- the second material having an electrical conductivity higher than an electrical conductivity of the first material.

2. Electronic component box (9) according to claim 1, wherein the second material has an electrical conductivity of at least
- a 10⁹times higher than the electrical conductivity of the first material expressed in S/m at 293°K, and/or
- 10⁶ S/m at 293°K, or
- 10⁷ S/m at 293°K.

3. Electronic component box (9) according to any one of the preceding claims, wherein the thickness of the casing (11) is in the range of 1.5 - 4 mm and the first material is or comprises a
- thermoplastic, and/or
- polycarbonate (PC), and/or
- acrylonitrile butadiene styrene (ABS) and/or
- mixture of polycarbonate and acrylonitrile butadiene styrene (PC + ABS) and/or
- fibre or glass fibre.

4. Electronic component box (9) according to any one of the preceding claims, wherein the second material is or comprises graphene.

5. Electronic component box (9) according to any one of the preceding claims, wherein the second material is provided as a coating layer on the first material, the coating layer being provided on a side of the casing (11) facing the inner space and/or on a side of the casing (11) facing an outer space of the casing (11).

6. Electronic component box (9) according to claim 5, wherein the thickness of the coating layer is greater than 0.34 nm and/or less than 7 nm.

7. Electronic component box (9) according to any one of the claims 1 - 4, wherein the first and second materials are mixed in a ratio of between 5 - 200 gram of the second material per litre of the first material.

8. Electronic component box (9) according to any one of the preceding claims, wherein the casing (11) comprises one or more sections made from
- the first material only and/or
- without the second material.

9. Electronic component box (9) according to any one of the preceding claims, wherein the casing (11) comprises ventilation openings.

10. Electronic component box (9) according to any one of the preceding claims, wherein the electronic component box (9) is configured to be attached to the heat pump system (1) by means of at least one hinge (20) to move the electronic component box (9) between an operating position and a range of maintenance positions, wherein the at least one hinge (20) has at least one stop position associated with a maintenance position to hold the electronic component box (9) in such maintenance position.

11. Electronic component box (9) according to any one of the preceding claims, wherein the inner space comprises an intermediate plane (14) defining a first and a second space, wherein
- the first space comprises or is configured to comprise electronic cards and power management elements, and/or
- the second space comprises or is configured to comprise electrical wirings, and/or
- the intermediate plane comprises openings to accommodate wiring to run between the first and second space, and/or
- the casing comprises a main body part (12) defining an opening and at least one moveable or removeable cover part (13) to cover the opening, wherein the first space is closer to the opening than the second space.

12. Heat pump system (1) comprising an electronic component box (9) according to any one of the preceding claims.

13. A method for manufacturing an electronic component box (9) for a heat pump system (1), wherein the electronic component box (9) comprises a casing (11) that is arranged to hold electronic components (15) in an inner space of the casing (11), wherein method comprises
- providing a first material, the first material being plastic,
- providing a second material, the second material having an electrical conductivity higher than an electrical conductivity of the first material,
- forming the casing (11) from the first and second material.

14. Method according to claim 13, wherein forming the casing (11) from the first and second material comprises:
- shaping the first material to form the casing (11), the casing (11) being shaped to hold at least one of the electronic components (15) at a fixed position within the casing (11), and
- applying a coating layer of the second material on at least parts of the casing (11).

15. Method according to claim 13, wherein forming the casing (11) from the first and second material comprises:
- mixing the first and second material to form a mixed material,
- shaping the mixed material to form the casing (11), the casing (11) being shaped to hold at least one of the electronic components (15) at a fixed position within the casing (11).
